# EUROPÄISCHE PATENTSCHRIFT

(11) **EP 2 389 535 B1**
(45) Veröffentlichungstag und Bekanntmachung des Hinweises auf die Patenterteilung: **10.07.2013**
(21) Anmeldenummer: 10720736.7
(22) Anmeldetag: 11.05.2010
(51) Int. Cl.: F21S 4/00, F21V 31/00, H05K 1/18, F21Y 101/02

(54) **LEUCHTBAND UND VERFAHREN ZUM HERSTELLEN EINES LEUCHTBANDS**
LIGHT BAND AND METHOD FOR PRODUCING A LIGHT BAND
BANDE LUMINEUSE ET SON PROCÉDÉ DE PRODUCTION

(30) Priorität: 12.05.2009 DE 102009020851
(43) Veröffentlichungstag der Anmeldung: 30.11.2011
(73) Patentinhaber: OSRAM GmbH, 80807 München (DE)
(72) Erfinder: BENKART, Ulrich, 86447 Aidling-Binnenbach (DE); KAMPFRATH, Andreas, 89168 Niederstrotzingen (DE); LAUERER, Anton, 93339 Riedenburg (DE)
(86) Internationale Anmeldenummer: PCT/EP2010/056459
(87) Internationale Veröffentlichungsnummer: WO 2010/130735

(56) Entgegenhaltungen:
- EP-A1- 1 980 785
- DE-A1- 10 051 528
- DE-A1- 10 102 353
- DE-A1- 19 640 718
- DE-A1-102006 031 345
- DE-A1-102007 028 463
- DE-A1-102007 043 401
- DE-U1-202006 002 728
- US-A- 4 173 035
- US-A1- 2005 007 033
- US-B1- 6 673 293

## Beschreibung

Die Erfindung betrifft ein Leuchtband, insbesondere ein IPgeschütztes LED-Band, und ein Verfahren zum Herstellen eines Leuchtbands.

Es sind mit Leuchtdioden ausgestattete flexible Bänder (LED-Flex-Bänder) bekannt, die ohne Funktionsverlust in LED-Module teilbar sind und mit einer selbstklebenden Rückseite ausgestattet sind. So ist beispielsweise die LINEARlight Flex-Reihe der Fa. Osram bekannt, bei der ein LED-Band auf einer Rolle aufgewickelt erhältlich ist (z. B. Reihe LM1X), wobei das LED-Band je nach Ausführung 120 bis 600 LEDs umfasst. Das Grundmaß des LED-Bands (L x B x H) beträgt 8400 mm x 10 mm x 3 mm. Das Grundmaß eines LED-Moduls mit zehn LEDs (L x B) beträgt 140 mm x 10 mm. Die LED-Bänder oder die LED-Module sind über proprietäre Konnektoren, z.B. aus der CONNECTSystem-Serie der Fa. Osram GmbH, mechanisch und elektrisch miteinander als auch mit einer Stromversorgung verbindbar.

Ferner sind LED-Bänder bekannt, die zur Herstellung eines IP-Schutzes in ein in Längsrichtung bandförmiges U-Profil eingelegt und dann mit einer transparenten Vergussmasse vollständig vergossen werden. Ein so vergossenes LED-Band kann aufgrund der durchgängigen Oberfläche aus Vergussmasse bei einer Biegung des Leuchtmoduls Risse zwischen den Leuchtdioden und der Vergussmasse verhindern, welche zu einem Eindringen von Schmutz oder Feuchtigkeit führen könnten.

DE 10051528 offenbart ein Leuchtband gemäβ dem ersten Teil des Anspruchs 1.

Es ist die **Aufgabe** der vorliegenden Erfindung, eine besonders einfach herstellbare und zuverlässig dichtende Möglichkeit einer Kontaktierung eines konfektionierbaren Leuchtbands bereitzustellen.

Diese Aufgabe wird gemäß den Merkmalen der unabhängigen Ansprüche gelöst. Bevorzugte Ausführungsformen sind insbesondere den abhängigen Ansprüchen entnehmbar.

Das Leuchtband weist einen bandförmigen Träger für mindestens eine Lichtquelle auf, wobei der Träger mit elektrischen Kontakten ausgerüstet ist. Das Leuchtband weist ferner mindestens eine an dem Träger befestigte Dichthaube auf, wobei die Dichthaube zumindest einen der elektrischen Kontakte zumindest teilweise überwölbt.

Durch die Befestigung der Dichthaube wird ein Aufnahmeraum zum Einführen eines Steckverbinders gebildet, da die Dichthaube die elektrischen Kontakte typgemäß beabstandet bzw. mit einem Abstand überwölbt. Die elektrischen Kontakte liegen zum Aufnahmeraum hin frei. Der Steckverbinder kann somit nach Einführung in den Aufnahmeraum den zumindest einen elektrischen Kontakt kontaktieren.

Die Dichthaube dichtet den Aufnahmeraum gegen den übrigen Bereich des Leuchtbands ab, so dass für eine Aufrechterhaltung eines Schutzes, insbesondere IP-Schutzes, des Leuchtbands nur noch der Aufnahmeraum an sich abgedichtet zu werden braucht. Dies ist besonders einfach möglich, da die Dichthaube einen gut definierten Aufnahmeraum zur Verfügung stellt, in welchen der Steckverbinder ohne weiteren Anpassungsaufwand und zuverlässig passend einsetzbar ist; dadurch ist eine dichte Steckermontage auch durch einen technisch nicht vorgebildeten Endkunden ohne einen Verlust einer IP-Klassifizierung möglich. Als ein Steckverbinder kann ein bereits verfügbarer Steckverbinder verwendet werden. Die Dichthaube ist preiswert herstellbar und zudem einfach und verlässlich auf den Träger aufsetzbar.

Der Träger kann ein flexibler oder biegsamer Träger, ein teilweise flexibler Träger oder ein starrer Träger sein. Durch die vergleichsweise kompakt ausgestaltbare Dichthaube verliert auch ein flexibler Träger nicht wesentlich an Biegefähigkeit.

Die Art der Lichtquelle ist nicht beschränkt. In einer Ausgestaltung kann die mindestens eine Lichtquelle eine Kompaktleuchtstoffröhre umfassen. In einer anderen Ausgestaltung kann die mindestens eine Lichtquelle eine Halbleiter-Lichtquelle wie eine Leuchtdiode und / oder einen Diodenlaser umfassen.

Die Lichtquelle kann beispielsweise eine Leuchtdiode oder mehrere Leuchtdioden umfassen. Die einzelnen Leuchtdioden können jeweils einfarbig oder mehrfarbig, z. B. weiß, abstrahlen. Bei Vorliegen mehrerer Leuchtdioden pro Lichtquelle können diese z. B. gleichfarbig (einfarbig oder mehrfarbig) und / oder verschiedenfarbig leuchten. So können mehrere Einzel-LEDs zusammen ein weißes Mischlicht ergeben, z. B. in 'kaltweiß' oder 'warmweiß'. Zur Erzeugung eines weißen Mischlichts können beispielsweise Leuchtdioden zusammengefasst sein, die in den Grundfarben rot (R), grün (G) und blau (B) leuchten. Dabei können einzelne oder mehrere Farben auch von mehreren LEDs gleichzeitig erzeugt werden; so sind Kombinationen RGB, RRGB, RGGB, RGBB, RGGBB usw. möglich. Jedoch ist die Farbkombination nicht auf R, G und B (und A) beschränkt. Zur Erzeugung eines warmweißen Farbtons können beispielsweise auch eine oder mehrere bernsteinfarbige LEDs 'amber' (A) vorhanden sein. Bei LEDs mit unterschiedlichen Farben können diese auch so angesteuert werden, dass sie in einem durchstimmbaren RGB-Farbbereich abstrahlen. Zur Erzeugung eines weißen Lichts aus einer Mischung von blauem Licht mit gelbem Licht können auch mit Leuchtstoff versehene blaue LED-Chips verwendet werden, z. B. in Oberflächenmontagetechnik, z. B. in Thin-GaN-Technik. Durch eine Verwendung mehrerer weißer Einzel-Chips lässt sich eine einfache Skalierbarkeit des Lichtstroms erreichen. Die Einzel-Chips und / oder die LED-Gruppen können mit geeigneten Optiken zur Strahlführung ausgerüstet sein, z. B. Fresnel-Linsen, Kollimatoren, und so weiter. Statt oder zusätzlich zu anorganischen Leuchtdioden, z. B. auf Basis von InGaN oder AlInGaP, sind allgemein auch organische LEDs (OLEDs) einsetzbar.

In einer weiteren Ausgestaltung können zumindest einige der elektrischen Kontakte im Bereich zumindest einer der beiden Stirnseiten (stirnseitig) des Trägers angeordnet sein, was insbesondere eine Steckverbindung mit dem Leuchtband erleichtert. Für eine beidseitige Kontaktierung sind vorteilhafterweise im Bereich beider Stirnseiten elektrische Kontakte angeordnet.

Es kann eine Weiterbildung sein, dass die Dichthaube mindestens ein innenliegendes Dichtungselement aufweist. Unter einem innenliegenden Dichtungselement kann insbesondere ein in den Aufnahmeraum gerichtetes (ein an einer Innenseite der Dichtungshaube angeordnetes) Dichtungselement verstanden werden. Dadurch kann der Aufnahmeraum noch zuverlässiger gegen Fremdkörper (Staub usw.) und / oder Feuchtigkeit abgedichtet werden, und zwar auch ohne einen besonders angepassten Steckverbinder.

Alternativ oder zusätzlich kann das mindestens eine Dichtungselement an einer Außenseite der Dichtungshaube angeordnet sein, z.B. bei einem über die Dichthaube aufzusteckenden Steckverbinder.

Das mindestens eine Dichtungselement kann bezüglich einer Umfangsrichtung durchgehend an der Dichthaube angeordnet sein, um ein Eindringen von Fremdpartikeln und Feuchtigkeit noch effektiver zu unterdrücken.

Es kann eine Ausgestaltung sein, dass das mindestens eine Dichtungselement mindestens eine Dichtlippe aufweist. Diese kann einfach mit oder an der Dichthaube ausgebildet werden.

Es können zur Verstärkung der Dichtwirkung mehrere Dichtungselemente, insbesondere Dichtlippen, hintereinander angeordnet sein.

Es kann noch eine Weiterbildung sein, dass die Dichthaube ein Gehäuse mit einer offenen Unterseite aufweist, wobei die Unterseite durch den Träger geschlossen ist. Die Dichthaube und der Träger begrenzen bzw. bilden dann den Aufnahmeraum. Die Dichthaube kann insbesondere einen (umgekehrt) U-förmigen Profilquerschnitt aufweisen. Der U-förmige Profilquerschnitt kann im Bereich seiner freien Kanten gerade oder gebogen sein. Die Dichthaube kann zur Bildung des Aufnahmeraums vorzugsweise einfach auf den Träger aufgesetzt werden, oder umgekehrt.

Die Dichthaube kann auf eine Oberseite (welche z.B. die mindestens eine Lichtquelle tragen kann) und / oder eine Unterseite (welche z. B. zur Befestigung des Trägers vorgesehen sein kann) des Trägers aufgesetzt werden, oder der Träger kann so in die offene Unterseite der Dichthaube eingesetzt werden, dass die Dichthaube und der Träger über eine Seitenfläche des Trägers miteinander verbunden sind.

Es kann eine weitere Ausgestaltung sein, dass die Dichthaube ein zumindest (bezüglich einer Längsausdehnung des Leuchtbands) mantelseitig geschlossenes Gehäuse bildet, welches zumindest eine Durchführung für zumindest einen der elektrischen Kontakte aufweist. Bei dem mantelseitig geschlossenen Gehäuse wird das Gehäuse mit derjenigen mantelseitigen Wand auf den Träger aufgesetzt, in der sich auch die Durchführungen befinden. Diese Ausgestaltung kann aufgrund der großen Kontaktfläche mit dem Träger besonders einfach und fest mit dem Träger befestigt werden. Mittels der Durchführungen kann zudem eine einfache Ausrichtung der Dichthaube erreicht werden. Diese Dichthaube kann im nicht-getrennten Zustand bis auf die Durchführungen vollständig geschlossen sein.

Es kann auch eine Ausgestaltung sein, dass die mindestens eine Dichthaube mindestens eine elektrisch leitfähige Buchse zur Aufnahme eines Kontaktstifts aufweist und die mindestens eine Buchse jeweils mit einem der elektrischen Kontakte elektrisch verbunden ist, insbesondere darauf aufliegt. Dadurch kann auch eine Anschlussmöglichkeit für eine Steckverbindung geschaffen werden, welche mindestens einen Anschlussstift aufweist.

Es kann zudem eine Ausgestaltung sein, dass die mindestens eine Buchse in einem Gehäuse eingegossen ist. Dies ergibt eine stabile und gut geschützte Anschlussmöglichkeit.

Es kann ferner eine Ausgestaltung sein, dass die mindestens eine Buchse mit dem jeweiligen elektrischen Kontakt verlötet ist. So wird eine sichere elektrische Verbindung gewährleistet.

Es kann noch eine weitere Ausgestaltung sein, dass die mindestens eine Dichthaube an einer Stirnseite des Leuchtbands angeordnet ist und zu der Stirnseite hin offen ist. Dadurch kann ein Steckverbinder ohne weitere Vorbereitungen in den Aufnahmeraum eingesteckt werden.

Es kann auch eine Ausgestaltung sein, dass die mindestens eine Dichthaube an einem innenliegenden Abschnitt des Trägers dichtend angeordnet ist und mindestens eine Trennstelle des Leuchtbands überwölbt. Diese Dichthaube ist somit nicht stirnseitig an dem Träger angeordnet, sondern entfernt davon an einem bezüglich der Längsausdehnung des Trägers innenliegenden Abschnitt. Die Dichthaube kann mindestens eine Trennstelle aufweisen, deren Position mit einer Position der Trennstelle des Leuchtbands im Wesentlichen übereinstimmt.

Das Leuchtband ist an der Trennstelle auftrennbar und folglich konfektionierbar. Ein Leuchtband kann eine oder mehrere Trennstellen aufweisen, welche vorteilhafterweise jeweils von einer Dichthaube überwölbt sind. In dieser Ausgestaltung dichtet die Dichthaube den von ihr abgedeckten Bereich des Trägers und insbesondere die elektrischen Kontakte gegen Staub und / oder Feuchtigkeit ab. Sollte das Leuchtband nicht an dieser Trennstelle aufgetrennt werden, kann die Dichthaube dauerhaft einen ausreichenden Schutz, beispielsweise für eine Aufrechterhaltung einer vorgesehenen IP-Schutzklasse, bieten.

Damit das Leuchtband auch mit der mindestens einen Dichthaube noch einfach konfektionierbar bleibt, weist die jeweilige Dichthaube vorteilhafterweise ebenfalls mindestens eine Trennstelle an einer insbesondere in Bezug auf die Längserstreckung des Leuchtbands im Wesentlichen mit der Trennstelle des Trägers übereinstimmenden Position auf. Dadurch können die Dichthaube und der Träger in einem gemeinsamen Trennvorgang getrennt werden. Die Trennstelle kann durch eine Markierung gekennzeichnet sein und / oder körperlich als eine Trennstelle ausgestaltet sein, z. B. durch ein Vorsehen einer oder mehrerer Kerben usw.

Alternativ kann die Dichthaube auch ohne eine dezidierte oder ausgeprägte Trennstelle bzw. deren Markierung auskommen. Dies kann beispielsweise vorteilhaft sein, wenn ein Nutzer eine Positionierung der Trennstelle des Trägers auch ohne eine Trennstelle an der Dichthaube erkennen kann, z. B. wenn die Dichthaube eine Sicht auf den Träger und damit auf dessen Trennstelle zulässt oder wenn der Träger eine Markierung außerhalb des von der Dichthaube überwölbten Bereichs aufweist, z.B. auf einer der Dichthaube abgewandten Seite oder seitlich der Dichthaube.

Das Leuchtband kann sowohl getrennte bzw. stirnseitig bereits offene Dichthauben aufweisen, und zwar an Stirnseiten des Leuchtbands, als auch innenliegende, nicht-getrennte Dichthauben. Durch eine Auftrennung des Leuchtbands an einer Trennstelle ergeben sich zwei getrennte Leuchtbänder, welche nun an der Trennstelle jeweils eine an dem Träger befestigte, stirnseitig offene Dichthaube aufweisen, wobei die jeweilige Dichthaube zumindest einen elektrischen Kontakt zumindest teilweise überwölbt.

Dazu können typischerweise auf beiden Seiten der Trennstelle des ungetrennten Leuchtbands elektrische Kontakte vorbereitet sein, welche im nicht getrennten Zustand elektrisch über die Trennstelle hinweg zumindest teilweise elektrisch miteinander verbunden sind und durch die Auftrennung elektrisch getrennt werden und dann als stirnseitig angeordnete Kontakte dienen.

Es kann eine weitere Ausgestaltung sein, dass das Leuchtband mehrere einstückig zusammenhängende, im Wesentlichen identische Einheitsträgerabschnitte ("Leuchtmodule") aufweist, wobei zwei benachbarte Leuchtmodule an einer gemeinsamen Trennstelle trennbar sind.

Die Dichthaube kann insbesondere aus einem trennbaren, insbesondere schneidbaren Material gefertigt sein. Dadurch kann sie in einem einheitlichen Herstellungsprozess vergleichsweise preiswert hergestellt werden. Das schneidbare Material kann insbesondere ein weichelastisches Material sein. Das weichelastische Material kann beispielsweise einen weichelastischen Kunststoff, Silikon oder Gummi umfassen. Zur einfachen Auftrennung auch bei einem Endanwender können die Dichthaube und das Leuchtband schneidbar sein, beispielsweise mit einem Messer und / oder mit einer Schere.

Es kann eine alternative Ausgestaltung sein, dass die Dichthaube Gehäusewände mit einem vergleichsweise harten Material und die Trennstelle aus einem vergleichsweise weichen Material aufweist. Das harte Material kann beispielsweise einen vergleichsweise harten Kunststoff wie PA, PU, PET oder POM, einen Hartgummi, hartes Silikon usw. umfassen, während die Trennstelle beispielsweise ein weicheres Material wie weich ausgestaltetes Silikon oder Gummi aufweist. Jedoch sind die Materialien nicht auf die genannten Materialien beschränkt, vielmehr können sämtliche für die vorbestimmte Dichtung geeignete Materialien verwendet werden, wie andere Kunststoffe oder Nicht-Kunststoffe. Bei einer nicht aufgetrennten Dichthaube kann die Trennstelle auch als eine Dehnungsfuge z.B. zum Ausgleich von Herstellungstoleranzen dienen. Die Dichthaube kann als ein Verbundbauteil aus dem vergleichsweise harten Material und dem vergleichsweise weichen Material aufgebaut sein.

Die Dichthaube kann gemäß einer Weiterbildung zumindest teilweise mit einem Schutzüberzug abgedeckt sein, um beispielsweise die Voraussetzungen für eine oder mehrere IP-Schutzklassen zu erfüllen. Der Schutzüberzug kann mindestens einen Schutzlack oder mindestens eine Vergussmasse umfassen.

Dabei kann die Dichthaube gemäß noch einer Weiterbildung zumindest teilweise mitlackiert oder mitvergossen sein, was eine stärkere Befestigung auf dem Träger ergibt und zudem Spalte zwischen der Dichthaube und dem Schutzüberzug vermeidet, durch die Feuchtigkeit und / oder Fremdpartikel eindringen können.

Eine Wandstärke der Dichthaube kann vorteilhafterweise zwischen ca. 0,3 mm und 0,4 mm betragen, um eine ausreichend große Fügefläche auch bei einem randseitigen Aufsatz auf den Träger zu Verfügung stellen zu können, insbesondere bei einer Verfügung mittels eines Klebstoffs.

Die Aufgabe wird auch durch ein Verfahren zum Herstellen eines Leuchtbands gelöst, bei dem (i) die mindestens eine Dichthaube auf den Träger aufgesetzt wird und folgend (ii) das Leuchtband zumindest teilweise vergossen wird.

Das Leuchtband kann beispielsweise zumindest an einer die Leuchtquellen aufweisenden Seite zumindest zwischen den Dichthauben vergossen sein. Der Träger kann zum leichteren Verguss in ein nach oben offenes Vergussprofil eingelegt sein, z. B. ein U-Profil oder ein C-Profil.

Es kann eine Ausgestaltung sein, dass ein Gehäuse der Dichthaube mit dem Träger vor dem Vergießen verklebt wird. Dadurch wird eine dichte Auflage der Dichthaube auf dem Träger während des Vergießens sichergestellt.

Es kann auch eine Ausgestaltung sein, dass die mindestens eine Buchse mit dem jeweiligen elektrischen Kontakt vor dem Vergießen verlötet wird. Dadurch wird eine sichere Kontaktierung der Buchsen auf dem Träger sichergestellt.

In den folgenden Figuren wird die Erfindung anhand von Ausführungsbeispielen schematisch genauer beschrieben. Dabei können zur Übersichtlichkeit gleiche oder gleichwirkende Elemente mit gleichen Bezugszeichen versehen sein.
- Fig.1: zeigt als Schnittdarstellung in Seitenansicht ein Leuchtband mit mehreren nicht-getrennten Dichthauben;
- Fig.2: zeigt das Leuchtband aus Fig.1 in einem Bereich einer getrennten Dichthaube;
- Fig.3: zeigt als Schnittdarstellung in Seitenansicht genauer eine Dichthaube gemäß einer ersten Ausführungsform;
- Fig.4: zeigt in Vorderansicht auf eine Schnittebene A-A aus Fig.3 die Dichthaube gemäß der ersten Ausführungsform;
- Fig.5: zeigt in einer Ansicht analog zu Fig.4 eine Dichthaube gemäß einer zweiten Ausführungsform;
- Fig.6: zeigt als Schnittdarstellung in Seitenansicht ein Leuchtband mit einer getrennten Dichthaube gemäß einer dritten Ausführungsform;
- Fig.7: zeigt als Schnittdarstellung in Seitenansicht ein Leuchtband mit einer aufgetrennten Dichthaube gemäß einer vierten Ausführungsform;
- Fig.8: zeigt in einer Schrägansicht die Dichthaube aus Fig.7;
- Fig.9: zeigt einen Prozessablauf zur Bestückung eines Trägers mit einer Dichthaube;
- Fig.10: zeigt als Schnittdarstellung in Seitenansicht ein Leuchtband mit einer Dichthaube gemäß einer vierten Ausführungsform.
- Fig.11: in Vorderansicht die Dichthaube gemäß der vierten Ausführungsform.

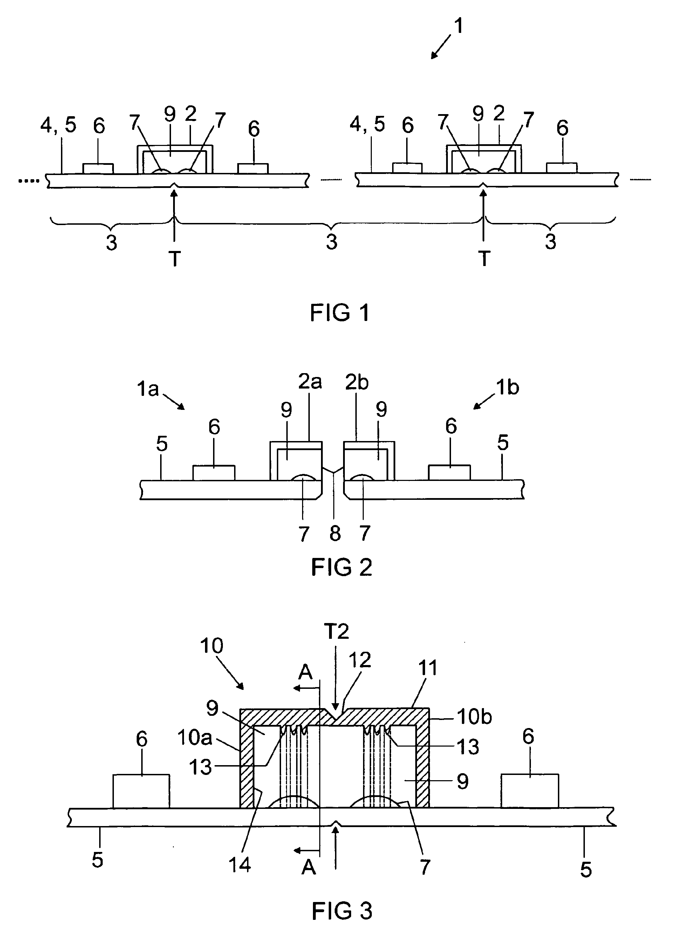

**Fig.1** zeigt als Schnittdarstellung in Seitenansicht ein Leuchtband 1 mit zwei Dichthauben 2. Das Leuchtband 1 ist aus mehreren identisch aufgebauten Leuchtmodulen 3 zusammengesetzt. Jedes der Leuchtmodule 3 weist einen bandförmigen, flexiblen Modulträger 5 auf, welcher an seiner Oberseite mit mehreren Leuchtdioden 6 bestückt ist. Die Modulträger 5 benachbarter Leuchtmodule 3 sind einstückig miteinander verbunden und an einer Trennstelle T trennbar. Auf beiden Seiten der Trennstelle T sind elektrische Kontakte 7 in Form von Lötpads vorbereitet, welche im hier gezeigten nicht-getrennten Zustand über die Trennstelle T hinweg miteinander elektrisch leitend verbunden sind und nach einer Auftrennung an der Trennstelle T elektrisch getrennt werden und dann als stirnseitig angeordnete Kontakte des jeweiligen Leuchtmoduls 3 dienen. Die einzelnen zusammenhängenden Modulträger 5 bilden zusammen einen Träger 4 des Leuchtbands 1.

Die Dichthauben 2 sind so auf dem bandförmigen, flexiblen Träger 4 aufgesetzt, dass sie jeweils zwei benachbarte Modulträger 5 an ihrer Trennstelle T zusammen mit den dort vorbereiteten Kontakten 7 dichtend überwölben. Dadurch kann der überwölbte Bereich des Trägers 4 vor Fremdkörpern wie Staub usw. und / oder vor Feuchtigkeit geschützt werden. Die jeweilige Dichthaube 2 und der Träger 4 bilden einen abgeschlossenen Aufnahmeraum 9, der für eine Aufnahme eines Steckverbinders vorbereitet ist.

Der Träger 4 bzw. seine Modulträger 5 können folgend zumindest in einem Bereich zwischen den Dichthauben 2 mit einem Schutzüberzug versehen werden, insbesondere zum Schutz der Leuchtdioden 6. Der Schutzüberzug kann z. B. eine Lackierung oder ein Verguss sein. Mittels des Schutzüberzugs kann beispielsweise eine bestimmte IP-Schutzklasse erreicht werden. Der Schutzüberzug kann auch die Dichthauben 2 zumindest teilweise überdecken.

An der Trennstelle T kann der Träger 4 zwischen den zwei Modulträgern 5 aufgetrennt werden. Dazu muss auch die zugehörige Dichthaube 2 aufgetrennt werden. Um eine leichte Auftrennung zu ermöglichen, besteht die Dichthaube 2 hier aus einem weichelastischen Material. Zur Erreichung einer definierten und sauberen Trennfläche kann als ein einfaches Trennverfahren ein Schneidverfahren vorteilhaft sein, z. B. mittels einer Schere.

Nach einer Trennung des Leuchtbands 1 an der Trennstelle T sind zwei neue, getrennte und folglich kürzere Leuchtbänder 1a, 1b entstanden, wie in **Fig.2** gezeigt. Die entsprechend getrennten Dichthauben 2a, 2b der zugehörigen Leuchtbänder 1a, 1b sind nun bezüglich jeweils des Leuchtbands 1a bzw. 1b stirnseitig angeordnet und zu ihrer Stirnseite 8 (welche der Stirnseite des Leuchtbands 1 entspricht) hin offen. Die getrennte Dichthaube 2a bzw. 2b bildet mit dem jeweiligen Modulträger 5 jeweils den stirnseitig offenen Aufnahmeraum 9 zur Aufnahme des Steckverbinders. Der Steckverbinder, z.B. ein Stecker, kann durch die offene Stirnseite 8 in den als eine Buchse dienenden Aufnahmeraum 9 eingeführt werden.

**Fig.3** zeigt als Schnittdarstellung in Seitenansicht genauer eine nicht-getrennte Dichthaube 10 gemäß einer ersten Ausführungsform. Die Dichthaube 10 kann beispielsweise als die Dichthaube 2 aus Fig.1 und Fig.2 verwendet werden. Das Gehäuse 11 der Dichthaube 10 ist aus einem weichelastischen Material ausgestaltet, welches z.B. mittels eines Messers oder einer Schere trennbar ist, z.B. aus Silikon oder Gummi. Damit ein Benutzer eine Trennstelle T des Trägers 4 einfach erkennen kann, ist auch auf der Dichthaube 10 eine Trennstelle T2 mittels einer Einkerbung 12 markiert.

In jeder der durch eine Trennung der Dichthaube 10 an den Trennstellen T, T2 dann entsprechenden getrennten Dichthauben 10a, 10b sind jeweils drei Reihen von elastischen Dichtlippen 13 angeordnet. Die Dichtlippen 13 verlaufen durchgehend auf einer Innenseite 14 der Dichthaube 10, d. h., dass die Dichtlippen 13 in den Aufnahmeraum 9 hineinragen. Durch die Dichtlippen 13 kann ein möglicher Spalt zwischen einem Steckverbinder und der Dichthaube 10 bzw. 10a, 10b zur Abdichtung des jeweiligen Aufnahmeraums 9 verschlossen werden.

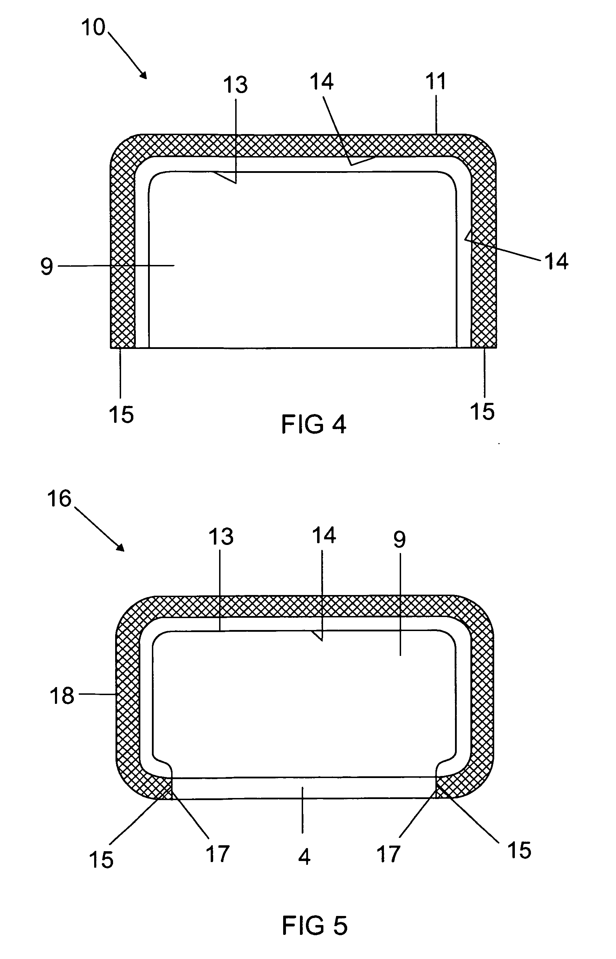

**Fig.4** zeigt in Vorderansicht auf eine Schnittebene A-A aus Fig.3 die Dichthaube 10 gemäß der ersten Ausführungsform. Das Gehäuse 11 weist eine umgekehrte U-Form mit abgerundeten Ecken auf. Das Gehäuse 11 ist dazu vorgesehen, mit seinen unteren freien Kanten 15 als Fügeflächen auf dem Träger 4 aufzusitzen und dort verklebt zu werden. Eine Wandstärke des Gehäuses 11 und damit eine Breite der Kanten 15 beträgt zwischen ca. 0,3 mm und 0,4 mm, um eine ausreichend hohe Klebekraft zu erlangen. Die Dichtlippen 13 verlaufen in einer Umfangsrichtung zur Längsrichtung des Trägers 4 durchgehend an der Innenseite 14 des Gehäuses 11.

**Fig.5** zeigt in einer Ansicht analog zu Fig.4 eine Dichthaube 16 gemäß einer zweiten Ausführungsform. Im Gegensatz zu der ersten Ausführungsform sind die unteren, freien Kanten 15 der Dichthaube 16 nun waagerecht nach Innen umgebogen. Die Dichthaube 16 ist mit diesen Kanten 15 als den Fügeflächen an Seitenflächen 17 des Trägers 4 befestigbar. Die Dichtlippen 13 sind auch hier in Umfangsrichtung durchgängig an der Innenseite 14 des Gehäuses 18 angeordnet.

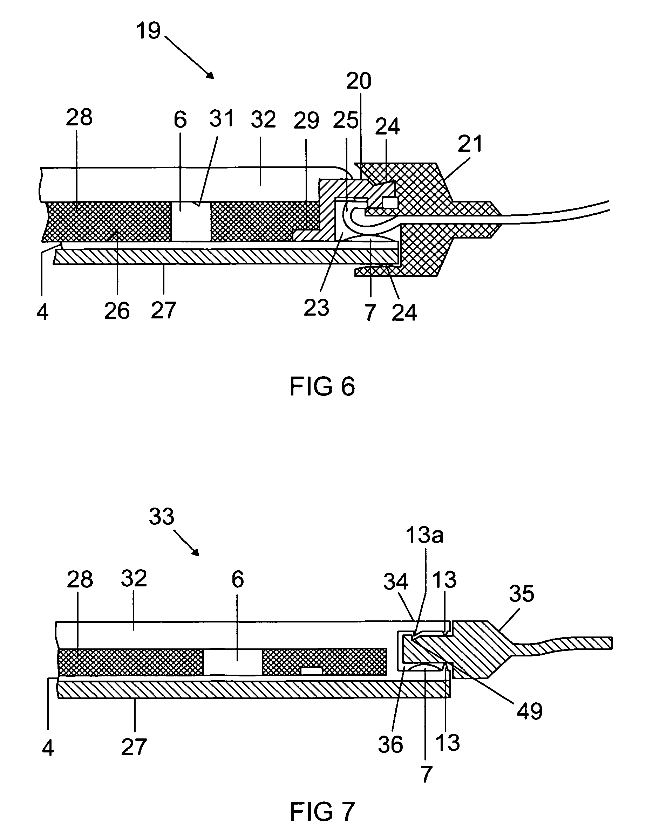

**Fig.6** zeigt als Schnittdarstellung in Seitenansicht ein Leuchtband 19 mit einer stirnseitig angeordneten, (auf)getrennten Dichthaube 20 gemäß einer dritten Ausführungsform. Der Träger 4 ist an seiner die LEDs 6 tragenden Oberseite 26 vergossen, und zwar zweifach. Eine erste, blickdichte Vergussmasse 28 aus biegsamem Silikon ist so auf dem Träger 4 so vergossen worden, dass eine oberseitige Emissionsfläche 31 der LEDs 6 nicht davon bedeckt ist. Die erste Vergussmasse 28 verhindert eine Sicht auf die Oberfläche des Trägers 4 mit den darauf aufgebrachten LEDs 6 (außer deren Emissionsflächen 31), Leiterbahnen und ggf. elektronischen Elementen. Auf die erste, blickdichte Vergussmasse 28 ist eine zweite, im Wesentlichen transparente Vergussmasse 32 aus biegsamem Silikon aufgebracht worden, welche ein von den LEDs 6 an der Emissionsfläche 31 nach oben abgestrahltes Licht nicht signifikant absorbiert. Diese beiden Vergussmassen 28, 32 schützen den Träger 4 mit den darauf aufgebrachten Komponenten z. B. zur Erfüllung einer bestimmten IP-Schutzklasse und halten eine Biegsamkeit des Leuchtbands 19 aufrecht.

Für ein einfaches Vergießen ist das Leuchtband 19 in eine U-förmige Profilschiene 27 eingelegt worden, von der hier die Unterseite sichtbar ist. Die Profilschiene 27 besteht ebenfalls aus Silikon, um eine Biegbarkeit des Leuchtbands 19 aufrechtzuerhalten.

Auf einen stirnseitigen Bereich des Leuchtbands 19 ist ein Stecker 21 von außen aufgeschoben worden, und zwar sowohl über die Dichthaube 20 als auch über den von der Dichthaube 20 überwölbten Teil des Trägers 4. Zur Abdichtung des Aufnahmeraums 23 weist nun der Stecker 21 in Umfangsrichtung umlaufende Dichtlippen 24 auf. In den Aufnahmeraum 23 wird mindestens ein Bügeldraht 25 zur Kontaktierung eines jeweiligen elektrischen Kontakts 7 eingeführt. Der Bügeldraht 25 dient auch zur Verrastung des Steckers 21 gegen ein unbeabsichtigtes Herausziehen. Hierzu verhakt sich der Bügeldraht 25 mit einer Dichtlippe 24 in der Dichthaube 20.

Die Dichthaube 20 weist einen nach hinten gerichteten Vorsprung 29 auf, welcher zur Vergrößerung der Kontaktfläche mit dem Träger 4 bzw. dem Modulträger 5 und damit einer besseren Befestigung dient.

Die Dichthaube 20 ist teilweise mitvergossen. Insbesondere der Vorsprung 29 dient auch zur besseren Verbindung mit der ersten Vergussmasse 28, von der er vollständig bedeckt ist. Durch den teilweisen Verguss auch der Dichthaube 20 kann eine Spaltbildung zwischen der Dichthaube 20 und den Vergussmassen 28, 32 unterdrückt werden und ein besserer Sitz der Dichthaube 20 auf dem Träger 4 erreicht werden.

**Fig.7** zeigt als Schnittdarstellung in Seitenansicht ein Leuchtband 33 mit einer aufgetrennten Dichthaube 34 gemäß einer vierten Ausführungsform.

Im Gegensatz zu der dritten Ausführungsform wird ein Stecker 35 zur elektrischen Kontaktierung des Leuchtbands 33 in den Aufnahmeraum 36 eingesteckt, und zwar durch eine stirnseitige Öffnung der Dichthaube 34. Der Stecker 35 kontaktiert an einer Seite, hier: seiner Unterseite, die elektrischen Kontakte 7 und liegt in Umfangsrichtung an einer innenliegenden Dichtlippe 13 der Dichthaube 34 an. Die Dichthaube 34 ist nicht mitvergossen, sondern lediglich der zwischen den Dichthauben 34 befindliche Teil des Trägers 4. Auch hier gibt es eine Sicherung gegen unbeabsichtigtes Herausziehen. Hierzu verhakt sich eine an der Dichthaube 34 befindliche Dichtlippe 13a in einer Kerbe 49 des Steckers 35.

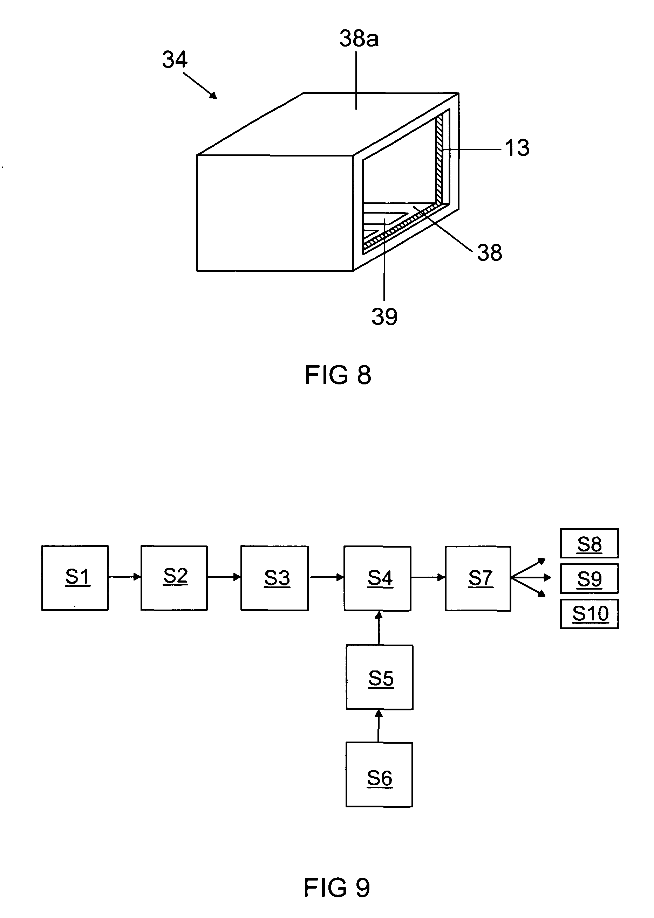

**Fig.8** zeigt in einer Schrägansicht die getrennte Dichthaube 34 aus Fig.7. Die Dichthaube 34 ist (bezüglich einer Längserstreckung des Leuchtbands 33) mantelseitig und rückwärtig geschlossen und also nur stirnseitig offen. Die Dichthaube 34 weist an der unteren Mantelseite 38 des Gehäuses 38a Durchführungen 39 zur Durchführung der elektrischen Kontakte 7 auf. Die Durchführungen 39 sind auch zur Positionierung der Dichthaube 34 auf dem Träger 4 geeignet. Die Dichthaube ist folglich im nicht-getrennten Zustand bis auf die Durchführungen 39 allseitig geschlossen. Die Dichtlippen 13 sind vollständig in Umfangsrichtung umlaufend ausgebildet.

**Fig.9** zeigt einen möglichen Prozessablauf zur Bestückung eines Trägers mit einer Dichthaube (Haubenmontage).

In einem Schritt S1 wird ein Quasi-Endlos-Nutzen abgespult. Unter einem Nutzen kann hier insbesondere ein zur besseren Verarbeitung aus mehreren bestückten oder unbestückten flexiblen, bandförmigen Quasi-Endlos-Trägern (Quasi-Endlos-Flexbändern) zusammengesetzter größerer Endlosträger verstanden werden, z.B. ein aus sechs parallel nebeneinander angeordneten Quasi-Endlos-Trägern zusammengesetzter Nutzen. Der Träger wiederum kann aus mehreren einstückig hintereinander verbundenen Modulträgern zusammengesetzt sein. Vorteilhafterweise können die Träger bereits mit den Lichtquellen und ggf. mit elektronischen Bauteilen bestückt sein, d.h., als Leuchtbänder vorliegen.

In einem folgenden Schritt S2 wird eine zur Montage der Dichthauben vorgesehene Oberfläche des Nutzens bzw. der Träger zumindest bereichsweise oberflächenbehandelt, z. B. plasmabehandelt, um die Oberfläche des Nutzens bzw. der Träger aufzurauhen.

Dadurch kann in einem folgenden Schritt S3 ein Haftmittel, insbesondere ein Klebstoff, gut haftend auf die Oberfläche aufgebracht werden. Das Haftmittel kann z. B. auf den Träger gestempelt werden oder im Rahmen eines Rakelprozesses aufgebracht werden.

Diese drei Schritte S1 bis S3 dienen der Vorbereitung des Trägers zur Verheiratung mit den Dichthauben.

In einem Schritt S4 werden die Dichthauben zugeführt. Die Dichthauben können beispielsweise in einem Tray, einem Blistergurt oder einem Tube zugeführt werden.

In einem darauf folgenden Schritt S5 werden die Dichthauben in ein Haftmittel eingetaucht, welches dem Haftmittels aus Schritt S3 entsprechen kann, es aber nicht braucht. So können die Haftmittel aus Schritt S3 und Schritt S5 zwei unterschiedlichen Komponenten eines Zwei-Komponenten-Klebers entsprechen. Alternativ zum Eintauchen der Dichthaube kann diese auch mit dem Haftmittel gestempelt oder gerakelt werden.

Diese beiden Schritte S4 und S5 dienen der Vorbereitung der Dichthauben zur Verheiratung mit dem Träger bzw. den Trägern.

Schritt S6 dient zur Verheiratung von Dichthaube(n) und Träger(n), z.B. im Rahmen eines "Pick-n'-Place"-Bestückungs-ablaufs.

In dem folgenden Schritt S7 wird der Klebstoff ausgehärtet, z.B. mittels einer Temperaturaushärtung oder einer UV-Aushärtung. Dadurch ist die Aufbringung der Dichthauben abgeschlossen.

In einem folgenden Schritt S8 kann der bestückte Nutzen wieder aufgespult werden und z. B. zur Weiterverarbeitung weitertransportiert oder gelagert werden.

In einem zu Schritt S8 alternativen Schritt S9 wird der Nutzen bzw. werden die Träger mit einem Schutzlack lackiert. Der Schutzlack kann beispielsweise eine Dickschicht sein. Ein mögliches Material eines Schutzlacks ist der UV-aushärtende Dickschichtlack der Lackwerke Peters Twin-Cure DSL 1600 E-FLZ.

Genauer kann Schritt S9 so durchgeführt werden, dass zunächst eine ausreichende Haftung der Dichthauben überprüft wird. Auch kann im Rahmen eines sogenannten "Light-Up"-Tests eine Funktion der Lichtquellen überprüft werden. Gegebenenfalls kann bei einer nicht ausreichenden Haftung einer oder mehrerer Dichthauben und / oder bei einem Ausfall einer oder mehrerer Lichtquellen der Nutzen nachbearbeitet werden. Danach wir der Nutzen mit dem Schutzlack lackiert und folgend der Schutzlack UV-ausgehärtet. In einem anschließenden Teilschritt wird der Nutzen in die einzelnen Träger bzw. Leuchtbänder aufgeteilt, insbesondere geschnitten. Die Träger bzw. Leuchtbänder werden dann aufgespult.

In einem zu den Schritten S8 und S9 alternativen Schritt S10 kann der Nutzen oder können vorteilhafterweise die vereinzelten Leuchtbänder mit Silikon vergossen werden.

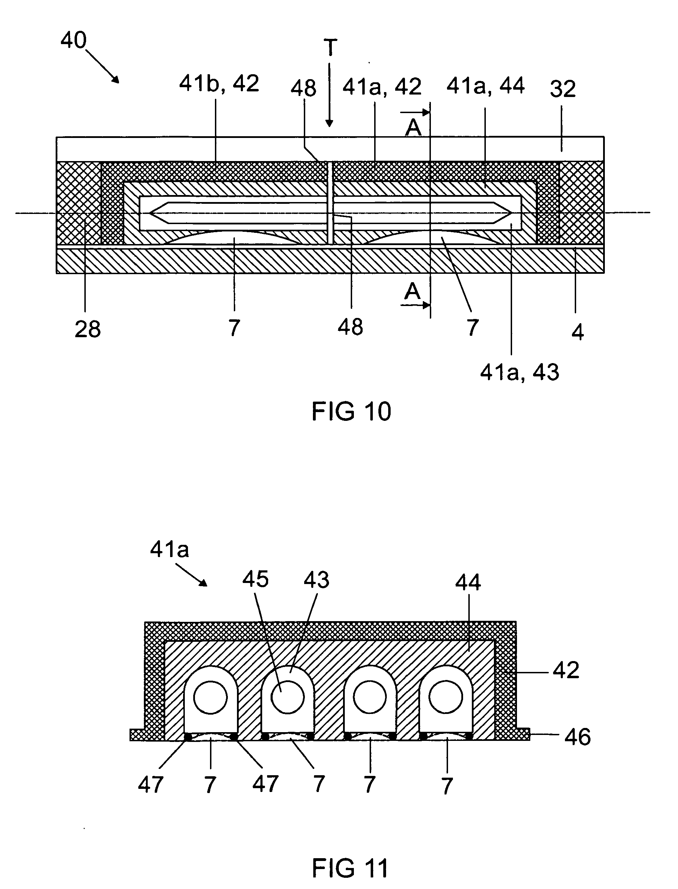

**Fig.10** zeigt als Schnittdarstellung in Seitenansicht ein Leuchtband 40 mit zwei sich an einer Trennstelle T spiegelsymmetrisch gegenüberliegenden Dichthauben 41a, 41b (Doppelanordnung) gemäß einer vierten Ausführungsform. **Fig.11** zeigt in Ansicht entlang einer Schnittebene A-A aus Fig.10 beispielhaft die Dichthaube 41a, welche identisch zu der Dichthaube 41b aufgebaut ist.

Bezug nehmend auf Fig.10 und Fig.11 weist jede der Dichthauben 41a, 41b ein nach unten offenes Gehäuse 42 auf, welches nun aber im Gegensatz zu den zuvor beschriebenen Ausführungsformen nicht hohl, sondern ausgefüllt ist. Dazu sind in das Gehäuse 42 hier beispielhaft vier einzelne metallische Buchsen 43 mittels einer Vergussmasse 44 eingegossen. Die Buchsen 43 weisen jeweils eine frontseitig offene Stiftaufnahme 45 in Form einer Senkbohrung zur Aufnahme eines jeweiligen, hier nicht gezeigten Kontaktstifts auf. Die Kontaktstifte können für eine sichere Aufnahme beispielsweise mit Federelementen (federnden Widerlagern o. ä.) oder als Feder aufgestaltet sein, einen oder mehrere Klemmhaken aufweisen und / oder eine konische Grundform mit einer etwas über eine Breite der Stiftaufnahme 45 hinausgehenden Breite aufweisen.

Die Unterseite der Buchsen 43 liegt frei, um bei einem Aufsetzen der Dichthaube 41a auf den Träger 4 einen jeweiligen elektrischen Kontakt 7 kontaktieren zu können. Die Buchsen 43 sind somit über die Breite entsprechend den elektrischen Kontakten 7 verteilt. Die Breite der Buchsen 43 entspricht vorteilhafterweise im Wesentlichen mindestens einer Breite der elektrischen Kontakte 7, wie in Fig. 11 gezeigt, um eine große Kontaktfläche zwischen den Buchsen 43 und dem jeweiligen elektrischen Kontakt 7 zu erlangen. Die Buchsen 43 können aus jedem geeigneten Material bestehen, beispielsweise aus Cu, Ag oder mit z. B. Au oder Ag beschichtetem VA.

Zur Befestigung der Dichthauben 41a, 41b auf dem Träger 4 können diese mittels des Gehäuses 42 auf den Träger 4 aufgeklebt werden. Beispielsweise zur Sicherstellung eines zur Haftung ausreichend großen Kontaktfläche und / oder zur Erreichung eines verbesserten Halts der Dichthaube 41a bzw. 42a bei einem Verguss weist das Gehäuse 42 an seinem unteren Rand eine umlaufende Kante 46 auf.

Alternativ oder zusätzlich können die Buchsen 43 verlötbar ausgestaltet sein und so nach Aufsatz der Dichthauben 41a, 41b mit dem elektrischen Kontakt 7 verlötet werden. Eine Dichthaube 41a, 41b kann dann auch als eine Art lötbare Lüsterklemme angesehen werden. Die Art der Lötung kann unterschiedlich sein und z. B. einen einfachen Lötvorgang oder ein SMD-Löten umfassen. Dazu können an der Unterseite der Buchsen 43 beispielsweise Lötvolumina 47 (Lötkugeln o. ä.) vorhanden sein.

Im Unterschied beispielsweise zu den Ausführungsformen aus Fig.6 oder Fig.7 reicht hier die erste, opake Vergussmasse 28 nur bis zu einer Oberkante der Dichthauben 41a, 41b. Die zweite, transparente Vergussmasse 32 ist in einem Vorgang auf die erste Vergussmasse 28 und die Dichthauben 41a, 41b aufgebracht worden. Es wird für eine einheitliche Farbgebung bevorzugt, dass die erste Vergussmasse 28 und die Dichthauben 41a, 41b eine im Wesentlichen gleiche Farbe aufweisen, z. B. weiß.

Zum Auftrennen des Leuchtbands 40 ist eine Trennstelle T zwischen den beiden Dichthauben 41a, 41b vorgesehen. Um eine Abdichtung der Vorderseite bzw. Stirnseite der Dichthauben 41a, 41b, insbesondere der frontseitig offenen Stiftaufnahmen 45, sicherzustellen, ist die Stirnseite der Dichthauben 41a, 41b mittels einer Dichtwand 48 abgedichtet. Die Dichtwand 48 kann beispielsweise als eine Elastomerhaut (insbesondere Silikonhaut) ausgebildet sein, z. B. als Teil einer Kappe. Zur Einbringung der Kontaktstifte in die Stiftaufnahmen 45 kann die Dichtwand 48 dort entweder entfernt, z. B. abgeschnitten oder abgekratzt, werden, oder die Kontaktstifte durchstoßen einfach die vergleichsweise dünne Dichtwand 48.

Das Gehäuse 42 kann bei der gezeigten Doppelanordnung sowohl trennbar als auch nicht-trennbar ausgestaltet sein. Das Gehäuse 42 kann beispielsweise aus einem weichelastischen Kunststoff, z. B. einem Elastomer (Gummi, Silikon usw.), oder einem harten Kunststoff bestehen. Das Gehäuse 42 kann zur einfachen und preiswerten Herstellung ein Spritzgussteil sein.

Selbstverständlich ist die vorliegende Erfindung nicht auf die beschriebenen Ausführungsbeispiele beschränkt.

Grundsätzlich kann eine Montage der Dichthauben an einem Nutzen oder an einstreifigen Trägern oder Leuchtbändern erfolgen.

Allgemein kann das Verkleben der Dichthaube(n) selbstklebend (z. B. mittels eines doppelseitigen Klebebands) oder mittels einer aktiven Kleberdosierung durchgeführt werden.

Alternativ zu einem Aufkleben der Dichthauben können die Dichthauben auch verlötet werden, insbesondere bei einer Montage auf einem (mehrstreifigen) Nutzen. Das Löten kann beispielsweise mittels einer Verwendung von Löteinlagen (z. B. Kupfereinlagen) oder Lötpads aus Kupfer o. ä. erfolgen, welche an der Dichthaube oder den Dichthauben vorhanden sind. Auf dem Träger bzw. den Trägern sind dann entsprechende Löteinlagen oder Lötpads vorhanden.

Sowohl bei der getrennten und mit einem Steckverbinder belegte Dichthaube als auch bei der nicht-getrennten Dichthaube kann der Aufnahmeraum nachträglich mit einem Dichtmittel (z. B. Silikongel) verfüllt werden, um eine Dichtigkeit noch weiter zu erhöhen. So kann das Dichtmittel durch die weichelastische Dichthaube hindurch in den Ausnahmeraum eingespritzt werden.

Die Zahl der Buchsen pro Dichthaube ist nicht beschränkt und kann eine oder mehrere Buchsen umfassen. Die Zahl der Buchsen kann typischerweise schaltungsabhängig ausgewählt sein.

**Bezugszeichenliste**

| | |
|---|---|
| 1 | Leuchtband |
| 1a | getrenntes Leuchtband |
| 1b | getrenntes Leuchtband |
| 2 | Dichthaube |
| 2a | getrennte Dichthaube |
| 2b | getrennte Dichthaube |
| 3 | Leuchtmodul |
| 4 | Träger |
| 5 | Modulträger |
| 6 | Leuchtdiode |
| 7 | elektrischer Kontakt |
| 8 | Stirnseite |
| 9 | Aufnahmeraum |
| 10 | Dichthaube |
| 10a | getrennte Dichthaube |
| 10b | getrennte Dichthaube |
| 11 | Gehäuse |
| 12 | Einkerbung |
| 13 | Dichtlippe |
| 13a | Dichtlippe |
| 14 | Innenseite |
| 15 | untere freie Kanten |
| 16 | Dichthaube |
| 17 | Seitenfläche des Trägers |
| 18 | Gehäuse |
| 19 | Leuchtband |
| 20 | aufgetrennte Dichthaube |
| 21 | Stecker |
| 22 | Unterseite |
| 23 | Aufnahmeraum |
| 24 | Dichtlippe |
| 25 | Bügeldraht |
| 26 | Oberseite |
| 27 | Profilschiene |
| 28 | erste Vergussmasse |
| 29 | Vorsprung |
| 31 | Emissionsfläche |
| 32 | zweite Vergussmasse |
| 33 | Leuchtband |
| 34 | Dichthaube |
| 35 | aufgetrennte Dichthaube |
| 36 | Aufnahmeraum |
| 37 | Stecker |
| 38 | Mantelseite |
| 38a | Gehäuse |
| 39 | Durchführung |
| 40 | Leuchtband |
| 41a | Dichthaube |
| 41b | Dichthaube |
| 42 | Gehäuse |
| 43 | Buchse |
| 44 | Vergussmasse |
| 45 | Stiftaufnahme |
| 46 | umlaufende Kante |
| 47 | Lötvolumen |
| 48 | Dichtwand |
| 49 | Kerbe |
| T | Trennstelle |
| T1 | Trennstelle |
| T2 | Trennstelle |

## Patentansprüche

1. Leuchtband (1;19;33;40), aufweisend
- einen bandförmigen Träger (4,5) für mindestens eine Leuchtquelle (6), insbesondere Leuchtdiode (6), wobei der Träger mit elektrischen Kontakten (7) ausgerüstet ist, **dadurch gekennzeichnet**, durch
- mindestens eine an dem Träger (4,5) befestigte Dichthaube (2, 2a, 2b; 10, 10a, 10b; 16; 34; 41a, 41b) mit einem Aufnahmeraum zum Einführen eines Steckverbinders, welche zumindest einen der elektrischen Kontakte (7) zumindest teilweise überwölbt,
- wobei der Träger (4,5) zumindest teilweise vergossen ist.

2. Leuchtband nach Anspruch 1, bei dem die Dichthaube (2, 2a, 2b; 10, 10a, 10b; 16; 34) mindestens ein innenliegendes Dichtungselement (13), insbesondere Dichtlippe (13), aufweist.

3. Leuchtband (1;19;40)nach einem der Ansprüche 1 oder 2, bei dem die Dichthaube (2,2a,2b;10,10a,10b;16; 41a,41b) ein Gehäuse (11;1842) mit einer offenen Unterseite aufweist, wobei die Unterseite durch den Träger (4) geschlossen ist.

4. Leuchtband (33) nach einem der Ansprüche 1 oder 2, bei dem die Dichthaube (34) ein zumindest mantelseitig geschlossenes Gehäuse (38a) bildet, welches zumindest eine Durchführung (39) für zumindest einen der elektrischen Kontakte (7) aufweist.

5. Leuchtband (40) nach einem der vorhergehenden Ansprüche, bei dem die mindestens eine Dichthaube (41a,41b) mindestens eine elektrisch leitfähige Buchse (43) zur Aufnahme eines Kontaktstifts aufweist und die mindestens eine Buchse (43) jeweils mit einem der elektrischen Kontakte (7) elektrisch verbunden ist, insbesondere darauf aufliegt.

6. Leuchtband (40) nach Anspruch 5, bei dem die mindestens eine Buchse (43) in einem Gehäuse (42) eingegossen ist.

7. Leuchtband (40) nach einem der Ansprüche 5 oder 6, bei dem die mindestens eine Buchse (43) mit dem jeweiligen elektrischen Kontakt (7) verlötet ist.

8. Leuchtband (1;19;33;40) nach einem der vorhergehenden Ansprüche, bei dem die mindestens eine Dichthaube (2a,2b;10a,10b;16;34;41a,41b) an einer Stirnseite (8) des Leuchtbands (1;19;33;40) angeordnet ist und zu der Stirnseite (8) hin offen ist.

9. Leuchtband (1;19;33;40) nach einem der vorhergehenden Ansprüche, bei dem
- die mindestens eine Dichthaube (2;10;16;34) an einem innenliegenden Abschnitt des Trägers (4,5) dichtend angeordnet ist und eine Trennstelle (T) des Leuchtbands (1;19;33;40) überwölbt.

10. Leuchtband (1;19;33;40) nach Anspruch 9, aufweisend mehrere einstückig zusammenhängende, im Wesentlichen identische Einheitsträgerabschnitte (5), welche an der Trennstelle (T) trennbar sind.

11. Leuchtband (1) nach einem der vorhergehenden Ansprüche, bei dem die Dichthaube (2,2a,2b) Gehäusewände mit einem vergleichsweise harten Material und eine Trennstelle (T2) aus einem vergleichsweise weichen Material aufweist.

12. Verfahren zum Herstellen eines Leuchtbands (1;19;33;40) nach einem der Ansprüche 8 bis 11, bei dem
- die mindestens eine Dichthaube (2;10;16;41a,41b) auf den Träger (4,5) aufgesetzt wird und folgend
- das Leuchtband (1;19;40) zumindest teilweise vergossen wird.

13. Verfahren nach Anspruch 12, bei dem ein Gehäuse (11;18;42) der Dichthaube (2;10;16;41a,41b) mit dem Träger (4,5) vor dem Vergießen verklebt wird.

14. Verfahren nach einem der Ansprüche 12 bis 13 zum Herstellen eines Leuchtbands (40) nach Anspruch 7, bei dem die mindestens eine Buchse (43) mit dem jeweiligen elektrischen Kontakt (7) vor dem Vergießen verlötet wird.

## Claims

1. Light strip (1; 19; 33; 40), having
- a strip-shaped carrier (4, 5) for at least one light source (6), in particular a light-emitting diode (6), wherein the carrier is equipped with electrical contacts (7), **characterized by**
- at least one sealing shroud (2, 2a, 2b; 10, 10a, 10b; 16; 34; 41a, 41b) with an accommodating area for inserting a plug-type connector, which sealing shroud is fastened to the carrier (4, 5) and arches at least partially over at least one of the electrical contacts (7),
- wherein the carrier (4, 5) is at least partially cast.

2. Light strip according to Claim 1, in which the sealing shroud (2, 2a, 2b; 10, 10a, 10b; 16; 34) has at least one inner sealing element (13), in particular sealing lip (13).

3. Light strip (1; 19; 40) according to either of Claims 1 and 2, in which the sealing shroud (2, 2a, 2b; 10, 10a, 10b; 16; 41a, 41b) has a housing (11; 1842) with an open lower side, wherein the lower side is closed by the carrier (4).

4. Light strip (33) according to either of Claims 1 and 2, in which the sealing shroud (34) forms a housing (38a) which is closed at least on the lateral surface side and which has at least one bushing (39) for at least one of the electrical contacts (7).

5. Light strip (40) according to one of the preceding claims, in which the at least one sealing shroud (41a, 41b) has at least one electrically conductive socket (43) for accommodating a contact pin, and the at least one socket (43) is electrically connected in each case to one of the electrical contacts (7), in particular rests thereon.

6. Light strip (40) according to Claim 5, in which the at least one socket (43) is cast-in in a housing (42).

7. Light strip (40) according to either of Claims 5 and 6, in which the at least one socket (43) is soldered to the respective electrical contact (7).

8. Light strip (1; 19; 33; 40) according to one of the preceding claims, in which the at least one sealing shroud (2a; 2b; 10a, 10b; 16; 34; 41a, 41b) is arranged on an end side (8) of the light strip (1; 19; 33; 40) and is open towards the end side (8).

9. Light strip (1; 19; 33; 40) as claimed in one of the preceding claims, in which
- the at least one sealing shroud (2; 10; 16; 34) is arranged in sealing fashion on an inner section of the carrier (4, 5) and arches over a separation point (T) of the light strip (1; 19; 33; 40).

10. Light strip (1; 19; 33; 40) according to Claim 9, having a plurality of integrally joined, substantially identical unit carrier sections (5), which can be separated at the separation point (T).

11. Light strip (1) according to one of the preceding claims, in which the sealing shroud (2, 2a, 2b) has housing walls comprising a comparatively hard material and a separation point (T2) comprising a comparatively soft material.

12. Method for producing a light strip (1; 19; 33; 40) according to one of Claims 8 to 11, in which
- the at least one sealing shroud (2; 10; 16; 41a, 41b) is placed onto the carrier (4, 5) and then
- the light strip (1; 19; 40) is at least partially cast.

13. Method according to Claim 12, in which a housing (11; 18; 42) of the sealing shroud (2; 10; 16; 41a, 41b) is adhesively bonded to the carrier (4, 5) prior to casting.

14. Method according to one Claims 12 to 13 for producing a light strip (40) according to Claim 7, in which the at least one socket (43) is soldered to the respective electrical contact (7) prior to casting.

## Revendications

1. Bande lumineuse (1 ; 19 ; 33 ; 40), présentant
- un support en forme de bande (4, 5) pour au moins une source lumineuse (6), en particulier une diode électroluminescente (6), le support étant équipé de contacts électriques (7), **caractérisée par**
- au moins une structure de protection étanche (2, 2a, 2b ; 10, 10a, 10b ; 16 ; 34 ; 41 a, 41 b) fixée au niveau du support (4, 5) avec un espace de logement pour l'introduction d'un connecteur à fiches, laquelle structure recouvre au moins partiellement au moins un des contacts électriques (7),
- le support (4, 5) étant au moins partiellement encapsulé.

2. Bande lumineuse selon la revendication 1, dans laquelle la structure de protection étanche (2, 2a, 2b ; 10, 10a, 10b ; 16 ; 34) présente au moins un élément d'étanchéité interne (13), notamment une lèvre d'étanchéité (13).

3. Bande lumineuse (1 ; 19 ; 40) selon l'une des revendications 1 ou 2, dans laquelle la structure de protection étanche (2, 2a, 2b ; 10, 10a, 10b ; 16 ; 41 a, 41 b) présente un logement (11 ; 18 ; 42) avec une face inférieure ouverte, dans laquelle la face inférieure est fermée par le biais du support (4).

4. Bande lumineuse (33) selon l'une des revendications 1 ou 2, dans laquelle la structure de protection étanche (34) forme un logement (38a) fermé au moins sur le côté enveloppant, lequel logement présente au moins un passage (39) pour au moins un des contacts électriques (7).

5. Bande lumineuse (40) selon l'une des revendications précédentes, dans laquelle l'au moins une structure de protection étanche (41 a, 41 b) présente au moins une douille électriquement conductrice (43) pour loger une fiche de contact et l'au moins une douille (43) est reliée électriquement respectivement à l'un des contacts électriques (7), elle repose notamment dessus.

6. Bande lumineuse (40) selon la revendication 5, dans laquelle l'au moins une douille (43) est versée dans un logement (42).

7. Bande lumineuse (40) selon l'une des revendications 5 ou 6, dans laquelle l'au moins une douille (43) est soudée au contact électrique (7) respectif.

8. Bande lumineuse (1 ; 19 ; 33 ; 40) selon l'une des revendications précédentes, dans laquelle l'au moins une structure de protection étanche (2a, 2b ; 10a, 10b ; 16 ; 34 ; 41 a, 41 b) est disposée sur une face avant (8) de la bande lumineuse (1 ; 19 ; 33 ; 40) et est ouverte en direction de la face avant (8).

9. Bande lumineuse (1 ; 19 ; 33 ; 40) selon l'une des revendications précédentes, dans laquelle,
- l'au moins une structure de protection étanche (2 ; 10 ; 16 ; 34) est disposée de manière étanche sur une partie interne du support (4, 5) et recouvre un point de séparation (T) de la bande lumineuse (1 ; 19 ; 33 ; 40).

10. Bande lumineuse (1 ; 19 ; 33 ; 40) selon la revendication 9, présentant plusieurs parties de support d'unité (5) contiguës formant un seul élément pour l'essentiel identiques, qui sont séparables au niveau du point de séparation (T).

11. Bande lumineuse (1) selon l'une des revendications précédentes, dans laquelle la structure de protection étanche (2, 2a, 2b) présente des parois de logement avec un matériau comparativement rigide et un point de séparation (T) en matériau comparativement souple.

12. Procédé de fabrication d'une bande lumineuse (1 ; 19 ; 33 ; 40) selon l'une des revendications 8 à 11, dans lequel
- l'au moins une structure de protection étanche (2 ; 10 ; 16 ; 41 a, 41 b) est posée sur le support (4, 5) et ensuite
- la bande lumineuse (1 ; 19 ; 40) est au moins partiellement encapsulée.

13. Procédé selon la revendication 12, dans lequel un logement (11 ; 18 ; 42) de la structure de protection étanche (2 ; 10 ; 16 ; 41 a, 41 b) est collé au support (4, 5) avant l'encapsulation.

14. Procédé selon l'une des revendications 12 à 13 pour la fabrication d'une bande lumineuse (40) selon la revendication 7, dans lequel l'au moins une douille (43) est soudée au contact électrique (7) respectif avant l'encapsulation.
